(19) Europäisches Patentamt
European Patent Office
Office européen des brevets

(11) Veröffentlichungsnummer: **0 099 338**
**B1**

(12) **EUROPÄISCHE PATENTSCHRIFT**

(45) Veröffentlichungstag der Patentschrift: **14.05.86**

(51) Int. Cl.⁴: **C 08 L 63/00**, C 08 L 79/08

(21) Anmeldenummer: **83810313.3**

(22) Anmeldetag: **08.07.83**

(54) **Mit Thermoplasten modifizierte Epoxyharzsysteme.**

(30) Priorität: **14.07.82 US 397963**

(43) Veröffentlichungstag der Anmeldung: **25.01.84 Patentblatt 84/4**

(45) Bekanntmachung des Hinweises auf die Patenterteilung: **14.05.86 Patentblatt 86/20**

(84) Benannte Vertragsstaaten: **CH DE FR GB IT LI NL**

(56) Entgegenhaltungen:
**EP-A-0 013 767**
**FR-A-2 329 721**
**US-A-3 856 752**
**US-A-4 277 583**

(73) Patentinhaber: **CIBA-GEIGY AG, Klybeckstrasse 141, CH-4002 Basel (CH)**

(72) Erfinder: **King, John J., 26 Evergreen Place, Ridefield, CT 06877 (US)**
Erfinder: **Sellers, Ralph F., 71 Smith Road, Somerset New Jersey 08873 (US)**

**EP 0 099 338 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Zur Erhöhung der Zähigkeit von Duroplasten wurden grosse Anstrengungen unternommen. Üblicherweise wird dem System ein Gummi-Modifizierungsmittel beigegeben, das eine unlösliche zweite Phase bildet und die Weiterverbreitung von Rissen verhindert. Nach einer anderen Methode werden verschiedene Harze zusammengemischt, um für jedes Harz die optimalen Eigenschaften, z.B. thermische Eigenschaften und Zähigkeit, zu erhalten. Dies wird aber selten erreicht, da meistens nur ein optimaler Kompromiss der Eigenschaften möglich ist. Um bei gehärteten Harzen die notwendige Zähigkeit zu erreichen, müssen oft andere Eigenschaften, wie z.B. die chemische Beständigkeit oder die thermischen Eigenschaften, vernachlässigt oder reduziert werden. Solche Lösungen sind annehmbar, wenn auch unerwünscht, solange sie sich bei der Endanwendung des Harzes nicht nachteilig auswirken.

Epoxyharze sind typische Beispiele für solche Duroplaste, indem sie bezüglich verschiedener Eigenschaften, z.B. der Bruchdehnung oder der Gewichtsbelastbarkeit bei Beschädigung zu wünschen übrig lassen. Bei Versuchen, diese Harze zu modifizieren, wurden die oben erwähnten Methoden angewendet, besonders die Modifizierung mit Gummi.

Hauptaufgabe dieser Erfindung ist es deshalb, die Eigenschaften von Epoxyharzsystemen ohne wesentliche Beeinträchtigung der vorhandenen wünschbaren Eigenschaften zu verbessern.

Eine weitere Aufgabe ist es, die erwähnte Verbesserung der Zähigkeit und der mechanischen und thermischen Eigenschaften durch Einverleibung einer im wesentlichen diskontinuierlicher Phase in das Epoxyharzsystem zu erreichen.

Verschiedene andere Vorteile dieser Erfindung sind aus der folgenden Beschreibung ersichtlich.

Es wurde nun gefunden, dass überraschenderweise durch die Einverleibung eines thermoplastischen Polyimids in ein Epoxyharzsystem die Zähigkeit und die mechanischen und thermischen Eigenschaften des resultierenden Epoxyharzes ohne substantielle Beeinträchtigung der übrigen erwünschten Eigenschaften wesentlich verbessert werden. Das Polyimid bildet dabei ein semi-interpenetrierendes Netzwerk mit einer im wesentlichen diskontinuierlichen Phase in der kontinuierlichen Phase des Epoxyharzes. Die Anwesenheit des Polyimids als diskontinuierliche Phase und als Lunkerfüllstoff auf molekularer Ebene bewirkt die Verbesserung der oben erwähnten Eigenschaften. Das Polyimid kann ebenso einem Harz-Stoffgemisch beigegeben werden, um die Anfangsviskosität und/oder die Viskosität des Harzsystems während der Verarbeitung zu steuern. Viskositätserhöhungen werden üblicherweise durch schwer kontrollierbare Vorverlängerung des Harzes erreicht. Die Anwendung des Polyimids ermöglicht die Einstellung der Viskosität des Harzstoffgemisches nach Mass auf einen gewünschten bestimmten Wert. Solche Systeme eignen sich zur Herstellung von Verbundstoffen und Formmassen und für andere Anwendungen, bei denen ein kontrolliertes Fliessverhalten des Harzes nötig ist.

Die Zugabe von thermoplastischen Harzen zu Epoxyharzen ist bekannt. So wird z.B. in den U.S. Patentschriften No. 3,715,252, 3,737,352, 3,784,433, 3,796,624, 4,073,670 und 4,131,502 die Kombination von Epoxyharzen mit nicht-heisshärtbaren thermoplastischen Komponenten, wie Poly(vinylacetal), Nylon, Neoprengummi, Acrylnitrilgummi, Phenoxyharzen, Polysulfonen und α-Olefin-Copolymeren, erwähnt. Die U.S. Patentschrift 3,530,087 beschreibt Klebstoffgemische, die ein Epoxyharz und ein thermoplastisches Polysulfonharz enthalten. Die U.S. Patentschrift 3,641,195 beschreibt härtbare Stoffgemische aus einem Epoxyharz, dispergiert in einem thermoplastischen Copolymer eines α-Olefin-Kohlenwasserstoffes und eines Äthers oder Carbonsäureesters eines α-Olefins. Die U.S. Patentschrift 4,117,038 beschreibt Epoxyharzklebstoffe, die eine Polyglycidylverbindung, ein Acrylnitril-Butadien-Styrol-Propfpolymer und ein Copolymer aus Äthylen, Acrylsäure und Acrylat enthalten. Obwohl es sich bei allen diesen Systemen um Thermoplasten handelt, erbringen sie nicht die verbesserten Eigenschaften des vorliegenden Erfindungsgegenstandes, weil sie innerhalb des Epoxyharzes keine diskontinuierliche Phase bilden, und/oder das freie Volumen des Epoxyharzes nicht herabsetzen können.

Mischungen von Polyimiden mit Epoxyharzen sind dem Fachmann ebenfalls bekannt. So beschreibt z.B. die U.S. Patentschrift No. 4,237,262 Stoffgemische aus mindestens einem aliphatischen Epoxyharz und mindestens einem härtbaren Polyimid-Präpolymer, das aus einem aliphatischen Bis-Maleimid, einem aromatischen Polyamin und einem aromatischen Bis-Maleimid gebildet ist. Die deutsche Offenlegungsschrift No. 2,900,560 beschreibt Gemische aus Polyamid-Polyimid Harzen und Epoxyverbindungen. Die japanische Offenlegungsschrift No. 79/129,097 beschreibt Reaktionsprodukte aus einem ungesättigten Bisimid, einer phenolischen Verbindung und einer Epoxyverbindung. Die japanische Offenlegungsschrift No. 79/142,298 beschreibt Epoxyharze aus Bis(4-carboxyphthalimido)-Verbindungen und Polyepoxiden. Alle diese Systeme sind jedoch mit dem Erfindungsgegenstand nicht direkt vergleichbar.

Die erfindungsgemässen Stoffgemische enthalten (a) ein Epoxyharz mit mehr als einer Epoxygruppe, und (b) ein Polyimid, das im wesentlichen aus wiederkehrenden Einheiten der Formel

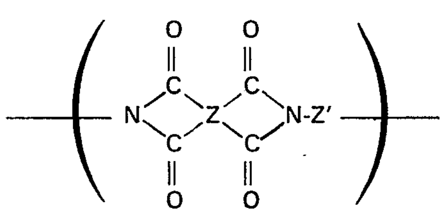

(I)

besteht, worin die vier Carbonylgruppen direkt an verschiedene Kohlenstoffatome gebunden sind und sich in ortho- oder peri-Stellung zueinander befinden, so dass fünf- oder sechsgliedrige Imidringe gebildet werden;

Z ein vierwertiger Rest ist, der mindestens einen

aromatischen Ring enthält, worin die Carbonylgruppen an den Ring gebunden sind, und

Z' ein zweiwertiger organischer Rest ist ausgewählt aus aromatischen, aliphatischen, alkylaromatichen, cycloaliphatischen und heterocyclischen Resten deren Kombinationen, und Resten mit Heteroatome enthaltenden überbrückenden Gruppen, wobei das Heteroatom in der Brücke Sauerstoff, Schwefel, Stickstoff, Silizium oder Phosphor ist; wobei das Polyimid (b) in einer Konzentration von 0,5 bis 50 Gewichtsprozent, bezogen auf das Stoffgemisch, und als eine im wesentlichen diskontinuierliche Phase innerhalb des Epoxyharzes vorliegt.

Die in der vorliegenden Erfindung anwendbaren Epoxyharze haben im Durchschnitt mehr als eine Epoxy-Gruppe pro Molekül, d.h. mehr als eine Gruppe der Formel

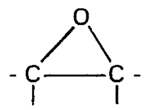

Dabei kann es sich um eine endständige Gruppe, d.h. eine Gruppe der Formel

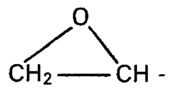

handeln, oder diese Gruppen können innerhalb der Kette bzw. des Netzwerks angeordnet sein.

Die Polyepoxide können gesättigt oder ungesättigt, aliphatisch, cycloaliphatisch, aromatisch oder heterocyclisch sein; sie können auch Substituenten, wie Chlor, Hydroxyl, Äther-Reste usw. aufweisen. Im allgemeinen können sie auf mehrwertigen Phenolen, wie z.B. Bisphenol A, F und S, auf epoxidierten Kresol- oder Phenol-Novolaken, auf Hydantoin-Epoxyharzen, Polyglycidyl-Estern, glycidylierten aromatischen Aminen, glycidylierten Aminophenolen und auf cycloaliphatischen Epoxyharzen basieren.

Beispiele solcher Polyepoxide sind unter anderem 1,4-Bis(2,3-epoxypropoxy)benzol, 1,3-Bis(2,3-epoxypropoxy)benzol, 4,4'-Bis(2,3-epoxypropoxy)diphenyläther, 1,8-Bis(2,3-epoxypropoxy)octan, 1,4--Bis(2,3-epoxypropoxy)cyclohexan, 2,2-[4,4'-Bis-(2-hydroxy-3,4-epoxybutoxy)diphenyl]propan, 1,3--Bis(4,5-epoxypentoxy)-5-chlorbenzol, 1,4-Bis(3,4--epoxybutoxy)-2-chlorcyclohexan, 1,3-Bis(2-hydroxy-3,4-epoxybutoxy)benzol und 1,4-Bis(2-hydroxy-4,5-epoxypentoxy)benzol.

Weitere geeignete Polyepoxide sind Epoxy-Polyäther mehrwertiger Phenole, hergestellt in alkalischem Medium aus halogenhaltigen Epoxiden oder Dihalohydrinen. Mehrwertige Phenole, die zu diesem Zweck gebraucht werden können, sind unter anderem Resorcinol, Catechol, Hydrochinon, Methylresorcinol oder mehrkernige Phenole, wie 2,2-Bis(4--hydroxyphenyl)propan (Bisphenol A), 2,2-Bis(4--hydroxyphenyl)butan, 4,4'-Dihydroxybenzophenon, Bis(4-hydroxyphenyl)äthan, 2,2-Bis(4-hydroxyphenyl)pentan und 1,5-Dihydroxynaphthalin. Die Halogen enthaltenden Epoxide können z.B. 3--Chlor-1,2-epoxybutan, 3-Brom-1,2-epoxyhexan, 3-Chlor-1,2-epoxyoctan und ähnliches sein. Wie in der U.S. Patentschrift No. 2,633,458 beschrieben, werden durch Veränderung des Verhältnisses von Phenol zu Epichlorhydrin Produkte verschiedenen Molekulargewichts erhalten.

Eine bevorzugte Gruppe der oben beschriebenen Epoxy-Polyäther mehrwertiger Phenole sind die Glycidyl-Polyäther zweiwertiger Phenole. Diese kann man durch Umsetzung der benötigten Mengen an zweiwertigem Phenol und Epichlorhydrin in alkalischem Medium erhalten. Die gewünschte Basizität wird durch Zugabe basischer Substanzen, wie z.B. Natrium- oder Kaliumhydroxids, bevorzugt in stöchiometrischem Überschuss zum Epichlorhydrin, erreicht. Die Reaktion wird vorzugsweise bei Temperaturen zwischen 50 und 150 °C durchgeführt. Das Erhitzen wird zur Beendigung der Reaktion mehrere Stunden fortgesetzt, und das Produkt wird dann von Salz und Base freigewaschen. Die Synthese von vier geeigneten Glycidyl-Polyäthern zweiwertiger Phenole ist in der U.S. Patentschrift No. 2,633,458 als Polyäther A, B, C und D beschrieben.

Eine andere Gruppe geeigneter Polyepoxide umfasst Polyepoxy-Polyäther, die durch Reaktion von mehrwertigen Alkoholen mit den oben erwähnten halogenhaltigen Epoxiden, wie Epichlorhydrin, vorzugsweise in Anwesenheit einer sauren Verbindung, wie Lewis-Säuren oder quarternärer Halogenide, und Behandlung des entstandenen Produktes mit einer basischen Verbindung erhalten werden. Der hier und im Folgenden gebrauchte Ausdruck «mehrwertiger Alkohol» beinhaltet Verbindungen, die mindestens zwei freie alkoholische OH-Gruppen haben und umfasst mehrwertige Alkohole und deren Äther und Ester, sowie Hydroxyaldehyde, Hydroxyketone, halogenierte, mehrwertige Alkohole und ähnliches. Mehrwertige Alkohole, die zu diesem Zweck gebraucht werden können, sind z.B. Glycerin, Propylenglykol, Äthylenglykol, Diäthylenglykol, Butylenglykol, Hexantriol, Sorbitol, Mannitol, Pentaerythrit, Polyllalkohol, Polyvinylalkohol, Mesitol, Trimethylolpropan, 2,2-[Bis(4-hydroxy-cyclohexyl)]-propan und ähnliches. Die Synthese geeigneter Polyepoxid-Polyäther ist in der U.S. Patentschrift No. 2,633,458 als Polyäther F beschrieben.

Besonders bevorzugte Verbindungen dieser Gruppe sind unter anderem z.B. Glycidylpolyäther aliphatischer mehrwertiger Alkohole 2 bis 10 Kohlenstoffatomen und 2 bis 6 Hydroxylgruppen, und insbesondere Glycidylpolyäther von Alkan-Polyolen mit 2 bis 8 Kohlenstoffatomen und 2 bis 6 Hydroxylgruppen. Diese Produkte haben vorzugsweise eine Epoxy-Funktionalität grösser als 1,0, besonders bevorzugt zwischen 1,1 und 4, und ein Molekulargewicht zwischen 300 und 1 000.

Eine andere Gruppe von Polyepoxiden beinhaltet Epoxyester polybasischer Säuren, wie z.B. Diglycidylphthalat, Diglycidyladipat, Diglycidyltetrahydrophthalat, Diglycidylmaleat, epoxidiertes Dimethyllallylphthalat und epoxidiertes Dicrotylphthalat.

Beispiele von Polyepoxiden mit internen Epoxygruppen sind unter anderem epoxidierte Ester von polyäthylenisch ungesättigten Monocarbonsäuren, wie z.B. epoxidiertes Leinsamen-, Sojabohnen-, Perilla-, Oiticika-, Tung-, Walnuss- und dehydriertes

Rizinusöl, epoxidiertes Methyllinoleat, Butyllinoleat, Äthyl-9,12-octadecadienoat, Butyl-9,12,15-octadecatrienoat, Ethyleleostearat, Monoglyceride von Tungöl-Fettsäuren, epoxydierte Monoglyceride des Sojabohnen-, Sonnenblumen-, Raps-, Hanfsamen-, Sardinen- und Baumwollsamenöls, und ähnliches.

Eine andere Gruppe epoxidierter Stoffe mit internen Epoxygruppen beinhaltet epoxidierte Ester ungesättigter Alkohole, die eine interne C=C-Doppelbindung haben, und Polycarbonsäuren, wie z.B. Di(2,3-epoxybutyl)adipat, Di(2,3-epoxybutyl)oxalat, Di(2,3-epoxyhexyl)succinat, Di(2,3-epoxyoctyl)tetrahydrophthalat, Di(4,5-epoxydodecyl)maleat, Di(2,3-epoxybutyl)terephthalat, Di(2,3-epoxypentyl)thiopropionate, Di(2,3-epoxyhexyl)succinat, Di(2,3-epoxyoctyl)tetrahydrophthalat, Di(4,5-epoxydodecyl)maleat, Di(2,3-epoxybutyl)terephthalat, Di(2,3-epoxypentyl)thiopropionat, Di(2,3-epoxybutyl)citrat und Di(4,5-epoxyoctadecyl)malonat, wie auch Ester von Epoxycyclohexanol und Epoxycyclohexylalkanolen, wie z.B. Di(2,3-Epoxycyclohexylmethyl)adipat und Di(2,3-epoxycyclohexylmethyl)phthalat.

Eine andere Gruppe von Stoffen mit internen Epoxygruppen sind epoxidierte Ester ungesättigter Alkohole und ungesättigter Carbonsäuren, wie z.B. 2,3-Epoxybutyl-3,4-epoxypentanoat, 3,4-Epoxyhexyl-3,4-epoxypentanoat, 3,4-Epoxycyclohexyl-3,4-epoxycyclohexanoat, 2,3-Epoxycyclohexylmethyl-2,3-epoxycyclohexanoat, 3,4-Epoxycyclohexyl-4,5-epoxyoctanoat und ähnliches.

Eine andere Gruppe von Stoffen mit internen Epoxygruppen sind epoxidierte Ester ungesättigter Monocarbonsäuren und polyhydrischer Alkohole, wie z.B. Äthylenglykoldi(2,3-epoxycyclohexanoat), Glycerintri(2,3-epoxycyclohexanoat) und Pentandioldi(2,3-epoxycyclooctanoat).

Schliesslich seien als weitere Beispiele von Epoxyverbindungen mit internen Epoxygruppen epoxidierte Derivate von polyäthylenisch ungesättigten Polycarbonsäuren, wie z.B. Dimethyl-8,9,11,12-diepoxyeicosandioat, Dibutyl-7,8,11,12-diepoxyoctadecandioat, Dioctyl-10,11-diethyl-8,9,12,13-diepoxyeicosandioat, Dicyclohexyl-3,4,5,6-diepoxycyclohexandicarboxylat, Dibenzyl-1,2,4,5-diepoxycyclohexan-1,2-dicarboxylate und Diäthyl-5,6,10,11-diepoxyoctadecylsuccinat genannt.

Vorzugsweise wird als Epoxyharz der Diglycidyläther von Bisphenol A oder ein Epoxidierungsprodukt eines Kresol-Novolaks oder eines Phenol-Novolaks verwendet.

Typische Polyimide (b) enthalten wiederkehrende Einheiten, worin Z ein Phenylindanrest der Formel II

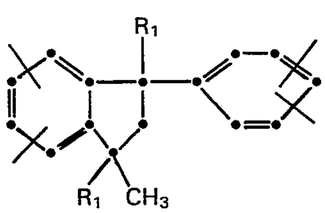

(II)

ist, worin $R_1$ ein Wasserstoffatom oder eine Alkylgruppe mit 1 bis 5 Kohlenstoffatomen ist, und

Z' ein Phenylindanrest der Formel

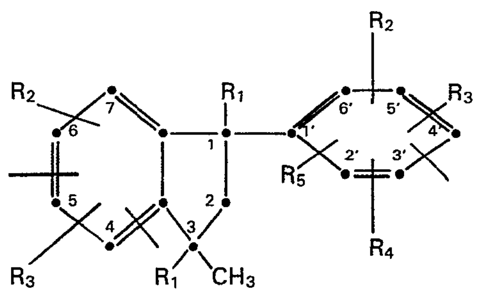

(III)

ist, worin $R_1$ ein Wasserstoffatom oder eine Alkylgruppe mit 1 bis 5 Kohlenstoffatomen ist, und

$R_2$, $R_3$, $R_4$ und $R_5$ unabhängig voneinander Wasserstoff, Halogen oder Alkyl mit 1 bis 4 Kohlenstoffatomen sind.

Die Phenylindandiamin-Komponente des Polyimids kann aus irgendeiner Kombination von Isomeren oder substituierten Isomeren der durch die obige Formel III bezeichneten Diaminoverbindungen bestehen. Die Phenylindandiamin-Komponente kann z.B. von 0 bis 100 Gew.-% 5-Amino-1-(4'-aminophenyl)-1,3,3-trimethylindan in Kombination mit 100 bis 0% Gew.-% 6-Amino-1-(4'-aminophenyl)-1,3,3-trimethylindan enthalten. Weiterhin können eines oder beide dieser Isomeren im ganzen Bereich von 0 bis 100 Gew.-% durch irgendeines der mit der Formel III bezeichneten substituierten Diaminoisomeren ersetzt werden. Beispiele solcher substituierter Diaminoisomeren sind 5-Amino-6-methyl-1-(3'-amino-4'-4'-methylphenyl)-1,3,3-trimethylindan, 5-Amino-1-(4'-amino-Ar',Ar'-dichlorphenyl)-Ar,Ar-dichlor-1,3,3-trimethylindan, 6-Amino-1-(4'-amino-Ar',-Ar'-dichlorphenyl)-Ar,Ar-dichlor-1,3,3-trimethylindan, 4-Amino-6-methyl-1-(3'-amino-4'-methylphenyl)-1,3,3-trimethylindan und Ar-Amino-1-(Ar'-amino-2',4'-dimethylphenyl)-1,3,3,4,6-pentamethylindan. Ar und Ar' in den obenerwähnten Verbindungen bezeichnen unbestimmte Stellungen der entsprechenden Substituenten an den Phenylringen.

Unter den Phenylindandiaminen der Formel III werden solche bevorzugt, worin $R_1$ Wasserstoff oder Methyl ist, $R_2$ und $R_3$ unabhängig voneinander Wasserstoff, Methyl, Chlor oder Brom, und $R_4$ und $R_5$ unabhängig voneinander Wasserstoff, Chlor oder Brom sind. Besonders bevorzugte Phenylindandiamine der Formel III sind solche, worin $R_1$ Wasserstoff oder Methyl ist, $R_2$ und $R_3$ unabhängig voneinander Wasserstoff, Methyl, Chlor oder Brom, und $R_4$ und $R_5$ unabhängig voneinander Wasserstoff, Chlor oder Brom sind, und die Aminogruppen in Stellung 5, 6 oder 7 und in Stellung 3' oder 4' sind. Am meisten bevorzugt sind Phenylindandiamine der Formel III, worin $R_1$ Wasserstoff oder Methyl ist, $R_2$, $R_3$, $R_4$ und $R_5$ Wasserstoff sind, und die Aminogruppen in Stellung 5 oder 6 und in Stellung 4' sind.

Z' ist besonders bevorzugt eine Gruppe der Formel

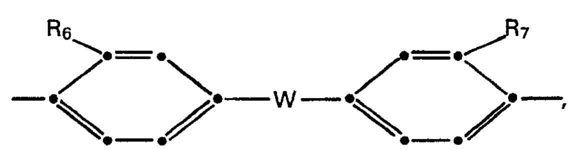

worin W eine kovalente Bindung, Methylen, Schwefel, Sauerstoff oder Sulfon ist, und $R_6$ und $R_7$ unabhängig voneinander Wasserstoff, Halogen oder Alkyl mit 1 bis 5 Kohlenstoffatomen, besonders Methyl, oder eine Gruppe der Formel

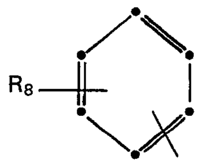

sind, worin $R_8$ Wasserstoff, Halogen oder Alkyl mit 1 bis 5 Kohlenstoffatomen, besonders Methyl ist.

Zusammen mit den Phenylindandiaminen kann ein breites Spektrum aromatischer Diamine, die keine Phenylindan-Struktur haben, wie z.B. substituierter Aniline und Benzidine, verwendet werden.

Die Phenylindandianhydrid-Komponente der löslichen Polyimide der vorliegenden Erfindung hat die Formel

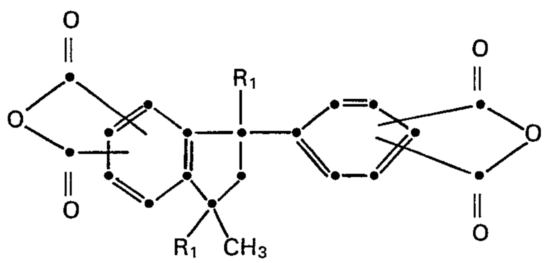 ,

worin $R_1$ Wasserstoff oder eine Alkylgruppe mit 1 bis 5 Kohlenstoffatomen ist. Beispiele solcher Dianhydride sind:

1-(3',4'-Dicarboxyphenyl)-1,3,3-trimethylindan-5,6-dicarbonsäuredianhydrid,

1-(3',4'-Dicarboxyphenyl)-1,3,3-trimethylindan-6,7-dicarbonsäuredianhydrid,

1-(3',4'-Dicarboxyphenyl)-3-methylindan-5,6-dicarbonsäuredianhydrid und

1-(3',4'-Dicarboxyphenyl)-3-methylindan-6,7-dicarbonsäuredianhydrid.

Weitere erfindungsgemäss geeignete Anhydride entsprechen der allgemeinen Formel

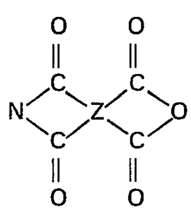 ,

worin der vierwertige Rest

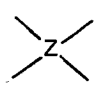

die oben angegebene Bedeutung hat.

Bevorzugt sind aromatische Dianhydride, in denen die Kohlenstoffatome von jedem Paar der Carbonylgruppen direkt an ortho- oder peri-Kohlenstoffatome der Gruppe Z gebunden sind, wobei z.B. die folgenden fünf- oder sechsgliedrigen Ringe

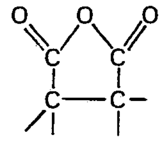 , 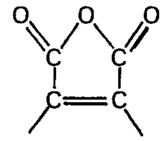 oder 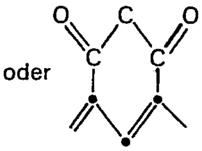

gebildet werden.

Folgende Verbindungen sind typische Tetracarbonsäurendianhydride, die erfindungsgemäss eingesetzt werden können:
2,3,9,10-Perylentetracarbonsäuredianhydrid, 1,4,-5,8-Naphthalintetracarbonsäuredianhydrid, 2,6-Dichlornaphthalin-1,4,5,8-tetracarbonsäuredianhydrid, 2,7-Dichlornaphthalin-1,4,5,8-tetracarbonsäuredianhydrid, 2,3,6,7-Tetrachlornaphthalin-1,-4,5,8-tetracarbonsäuredianhydrid, Phenanthren-1,8,9,10-tetracarbonsäuredianhydrid, 2,3,3',4'-Benzophenontetracarbonsäuredianhydrid, Pyromellitsäuredianhydrid, 3,3',4,4'-Benzophenontetracarbonsäuredianhydrid, 2,2',3,3'-Benzophenontetracarbonsäuredianhydrid, 3,3',4,4'-Biphenyltetracarbonsäuredianhydrid, 2,2',3,3'-Biphenyltetracarbonsäuredianhydrid, 4,4'-Isopropylidendiphthalsäuredianhydrid, 3,3'-Isopropylidendiphthalsäuredianhydrid, 4,4'-Oxydiphthalsäuredianhydrid, 4,4'-Sulfonyldiphthalsäuredianhydrid, 3,3'-Oxydiphthalsäuredianhydrid, 4,4'-Methylendiphthalsäuredianhydrid, 4,4'-Thiodiphthalsäuredianhydrid, 4,4'-Ethylidendiphthalsäuredianhydrid, 2,3,6,7-Naphthalintetracarbonsäuredianhydrid, 1,2,4,5-Naphthalintetracarbonsäuredianhydrid, 1,2,5,6-Naphthalintetracarbonsäuredianhydrid, Benzol-1,2,3,4-tetracarbonsäuredianhydrid, Pyrazin-2,3,5,6-tetracarbonsäuredianhydrid, Thiophen-2,3,4,5-tetracarbonsäuredianhydrid.

Bevorzugte Polyimide leiten sich von Diaminophenylindan und Benzophenontetracarbonsäuredianhydrid ab. Die verschiedenen Polyimide und deren Synthesemethoden sind ausführlich in der U.S. Patentschrift No. 3,856,752 beschrieben, die damit Bestandteil der vorliegenden Erfindung ist. Der Ausdruck «Polyimid» in der vorliegenden Erfindung beinhaltet Polyimide sowie auch deren Vorläufer, d.h. die Amidsäuren.

Allgemeine Methoden für die Herstellung modifizierter Epoxyharze umfassen entweder die einfache Kombination eines einzelnen Epoxyharzes oder eines Gemisches von Epoxyharzen mit einem oder mehreren Polyimiden, wenn diese Stoffe direkt ineinander löslich sind, oder das Lösen des Epoxyharzes oder der Epoxyharze in einem geeigneten Lösungsmittel, die Zugabe des Polyimids oder der Polyimide, und das Erhitzen des Gemisches auf eine Temperatur von 25 bis 100°C während 1 bis 2 Stunden, je nach Art des Lösungsmittels. Das Lösungsmittel wird dann entfernt, und es wird ein im allgemeinen klares, einheitliches, harzhaltiges Material erhalten. Unter «einheitlich» werden Systeme verstanden, welche entweder von Anfang an klar sind oder durch Erhitzen in einen klaren Zustand übergeführt werden können, sowie auch Systeme, die eine kleine Menge einer abgetrennten Phase enthalten, die aber ohne weiteres formuliert und zu wertvollen gehärteten Harzsystemen verarbeitet (ausgehärtet) werden können.

Dementsprechend kann das Polyimid auch als Teil

der Härter Komponente vor der Härtung beigegeben werden. Die Polyimide können dem Härter entweder direkt oder in Anwesenheit eines bevorzugt flüchtigen Lösungsmittels zugegeben, wenn nötig erhitzt und das Lösungsmittel entfernt, werden. Unabhängig davon, ob das Polyimid dem Epoxyharz oder dem Härter zugegeben wird, kann das Lösungsmittel durch das Erhitzen der Härtung entfernt werden.

Geeignete flüchtige Lösungsmittel beinhalten chlorierte Kohlenwasserstoffe, wie Methylenchlorid, Trichlorpropan oder Chloroform; Ester, wie Äthylacetat, Butylacetat oder Cellosolvacetat; Tetrahydrofuran; sowie Ätheralkohole, wie Methyl-, Äthyl-, oder Butyläther des Äthylenglykols. Diese Lösungsmittel können unter Beimischung von aromatischen Kohlenwasserstoffen und/oder einfachen Alkoholen benützt werden.

Die Konzentrationen der Polyimide werden so gewählt, dass sie die maximale Verbesserung der Eigenschaften bewirken. Geeignete Konzentrationen reichen von 0,5 bis 50 Gew.-% der gesamten Formulierung, bevorzugt von 1 bis 30 Gew.-% und besonders bevorzugt von 2 bis 10 Gew.-%.

Die nachfolgende Härtung der erfindungsgemässen Epoxyharzstoffgemische wird auf an sich bekannte Weise durchgeführt. Die Härtung findet von Raumtemperatur bis zu Temperaturen zwischen 120 und 300°C während einer angemessenen Zeit in Anwesenheit eines Härters statt. Der Härter wird vorzugsweise in stöchiometrischem Verhältnis ± 50%, bezogen auf das modifizierte Epoxyharzsystem eingesetzt, bevorzugt mit 1:1 Stöchiometrie.

Als Härter können z.B. aromatische Polyamine mit mindestens drei Amin-Wasserstoffatomen, wie p-Phenylendiamin, m-Phenylendiamin, Bis(4-aminophenyl)methan, Bis(4-aminophenyl)äther, Bis(4--aminophenyl)keton, Anilin-Formaldehyd-Harze, Bis(4-aminophenyl)sulfon, Bis(3-aminophenyl)sulfon und 2,4'-Diaminodiphenylsulfon, Polycarbonsäureanhydride, wie Maleinsäureanhydrid, Bernsteinsäureanhydrid, Dodecenylbernsteinsäureanhydrid, Polyazelainsäureanhydrid, Polysebacinsäureanhydrid, Phthalsäureanhydrid, Tetrahydrophthalsäureanhydrid, Hexahydrophthalsäureanhydrid, Endomethylentetrahydrophthalsäureanhydrid, Hexachloroendomethylentetrahydrophthalsäureanhydrid und Pyromellitsäuredianhydrid, sowie katalytische Härter, wie Dicyandiamid, Semicarbazid und Polyhydrazide, wie Isophthalyldihydrazid, Sebacyldihydrazid und Adipyldihydrazid, verwendet werden. Bevorzugte Härter sind Bis(4-aminophenyl)methan, Dicyandiamid und besonders Bis(4-aminophenyl)-sulfon, da sie während des Mischungsvorgangs mit dem Epoxyharz relativ unreaktiv sind, aber beim weiterem Erhitzen zu Produkten aushärten, die sich durch sehr hohe Haftfestigkeiten bei erhöhten Temperaturen auszeichnen.

Bei der Härtung bei erhöhten Temperaturen wird ein Netzwerk mit grosser Vernetzungsdichte gebildet. Dementsprechend bedeutet der Ausdruck Härtung wie hier gebraucht die Verwandlung der obenerwähnten Addukte und Epoxyverbindungen in unlösliche und nicht schmelzbare, vernetzte Produkte unter gleichzeitiger Verformung zu Formkörpern, wie Gussstücke, Presskörper oder Laminate, oder zu zweidimensionalen Strukturen, wie Überzüge, Emaillierungen oder Verklebungen. Die modifizierten Systeme sind wegen der erhöhten Zähigkeit der damit erhältlichen gehärteten Überzüge für Beschichtungen besonders geeignet.

Weiterhin betrifft die Erfindung ein Verfahren zur Verbesserung der Verarbeitungseigenschaften und/oder der mechanischen und thermischen Eigenschaften von Epoxyharzen, das dadurch gekennzeichnet ist, (i) dass man in ein Epoxyharz, mit mehr als einer Epoxygruppe als eine im wesentlichen darin diskontinuierliche Phase 0,5 bis 50 Gewichtsprozent, bezogen auf das Gesamtgemisch, eines vorher definierten Polyimids einverleibt, oder (ii) dass man in ein Epoxyharz mit mehr als einer Epoxygruppe oder in einen Härter für dieses Epoxyharz, vor der Härtung des Epoxyharz-Härter-Systems, 0,5 bis 50 Gewichtsprozent, bezogen auf das Gesamtgemisch, eines vorher definierten Polyimids einverleibt.

Die erfindungsgemäss hergestellten modifizierten Epoxyharze können weiterhin in jeder Stufe vor der Härtung mit üblichen Modifizierungsmitteln, wie Streckmitteln, Füllstoffen und Verstärkungsmitteln, Pigmenten, Farbstoffen, organischen Lösungsmitteln, Weichmachern, Haftvermittlern, Gummis oder Kautschuken, Beschleunigern, Verdünnern, usw. vermischt werden. Als Streckmittel, Verstärkungsmittel, Füllstoffe und Pigmente, die in den erfindungsgemässen härtbaren Gemischen verwendet werden können, kann man z.B. Kohleteer, Bitumen, Glasfasern, Borfasern, Kohlenstoff-Fasern, Cellulose, Polyäthylenpulver, Polypropylenpulver, Glimmer, Asbest, Quarzpulver, Gips, Antimontrioxid, Bentonit, Kieselsäure-Aerogel («Aerosil»), Lithopon, Barit, Titandioxid, Russ, Graphit, Eisenoxid, oder Metallpulver, wie Aluminium- oder Eisenpulver, erwähnen. Es ist auch möglich, den härtbaren Gemischen andere übliche Zusatzstoffe, wie z.B. Flammschutzmittel, Thixotropiemittel, Fliessmittel, wie Silikone, Celluloseacetat-Butyrat, Polyvinylbutyrat, Wachse, Stearate und dergleichen (die zum Teil auch als Entformungsmittel gebraucht werden) beizugeben.

In Klebstoff-Formulierungen ist es z.B. auch möglich, Gummis, wie carboxyl-terminiertes Acrylnitril-Butadien-Gummi, modifizierende Harze, wie Triglycidyl-p-aminophenol, und Beschleuniger wie Bortrifluorid-Monoäthylamin- oder Imidazol-Komplexe, beizugeben.

Die härtbaren Stoffgemische können auf übliche Art mit Hilfe bekannter Mischvorrichtungen (Rührer, Kneter, Walzen und dergleichen) hergestellt werden.

Modifizierte Harze, wie solche der oben beschriebenen Art sind auf weiten Gebieten anwendbar, wie z.B. als Verbundstoffe, gedruckte Schaltungen, Gusskörper, Pressstoffe, Klebstoffe und Überzüge. Wegen der charakteristischen verbesserten Eigenschaften besteht das grösste Interesse in der Anwendung für Hochleistungs-Verbundstoffe wie sie z.B. in der Luftfahrtindustrie verwendet werden. So werden die modifizierten Harze zum Vorimprägnieren von verschiedenen Fasern gebraucht, die schliesslich als Honigwabenschichten oder -strukturteile (Honey-Comb) eingesetzt werden können. Methoden zur Herstellung von Präpregs sind dem

Fachmann wohlbekannt. Mit dem erfindungsgemässen System kann man ohne weiteres Graphit-, Glas- und Kevlar-verstärkte oder auch andere Schichten und Teile für Honigwabenschichten und -strukturen herstellen. Entsprechende Methoden für die Herstellung von Laminaten sind auch bekannt. Solche Laminate können durch Formpressen oder mit der Autoklavenmethode, besonders durch Härtung und Formpressen eines mit dem vorher definierten härtbaren Gemisch imprägnierten Garnes, hergestellt werden und können unterschiedlich dick sein. Ein weiteres bevorzugtes Anwendungsgebiet sind die Klebstoffe, bei denen das erfindungsgemässe System die Klebeigenschaften wirkungsvoll verbessert.

Die modifizierten Systeme der vorliegenden Erfindung beinhalten zwei Grundkonzepte. Erstens ein semi-inter-penetrierendes Netzwerk, d.h. einen Duroplast in der kontinuierlichen Phase, und einen Thermoplast in der diskontinuierlichen Phase die zur Verbesserung der Zähigkeit und der mechanischen Eigenschaften von üblichen Duroplast-Harzen eingesetzt werden können. Dank ihrer Eignung als Lunkerfüllstoff auf molekularer Basis können sie zur Herabsetzung des vorhandenen freien Volumens verwendet werden, wodurch die thermischen und die mechanischen Eigenschaften des Systems verbessert werden. Schliesslich weisen die erfindungsgemässen Stoffgemische auch verbesserte Verarbeitungseigenschaften auf.

Die folgenden Beispiele veranschaulichen die bevorzugten Ausführungsformen dieser Erfindung. Falls nicht anders bezeichnet, handelt es sich bei Teilen in den Beispielen um Gewichtsteile.

*Beispiel 1*

*Herstellung eines typischen erfindungsgemässen, modifizierten Epoxyharzsystems.*

Ein Kolben wird mit 100 Teilen Bisphenol-A-Diglycidyläther (ARALDITE 6010 von CIBA-GEIGY Corp., U.S.A.) und 250 Teilen Methylenchlorid gefüllt. Diese Stoffe werden zu einem homogenen Gemisch vermischt. Anschliessend werden dem System langsam 10,4 Teile eines aus einem Gemisch von 5-Amino- und 6-Amino-1-(4-aminophenyl)--1,3,3-trimethylindan (35 Teile des 5-Isomeren und 65 Teile des 6-Isomeren) und 3,3',4,4'-Benzophenontetracarbonsäuredianhydrid hergestellten Polyimids zugegeben und eine Stunde damit vermischt. Die Lösung wird langsam zum Rückfluss erhitzt (ca. 44°C) und während ungefähr zwei Stunden rückflussiert. Nachher wird die Lösung auf Raumtemperatur gekühlt und filtriert. Die filtrierte Lösung wird in einen sauberen Kolben eingefüllt, destilliert, um das Lösungsmittel zu entfernen, und dann auf 120 bis 125°C erhitzt. Diese Temperatur wird aufrechterhalten, während der Druck allmählich auf 100 mm Hg gesenkt und so während 15 bis 20 Minuten gehalten wird. Das Vakuum wird gelöst, und das klare viskose Produkt wird heiss entleert. Dieses Verfahren ergibt 110,4 Teile eines klaren harzartigen Materials.

Gehärtete Harzplatten werden aus 110,4 Teilen des oben erwähnten Harzes und aus 30 Teilen Bis-(4-aminophenyl)sulfon hergestellt. Das Sulfon wird auf 200°C erhitzt und mit dem auf 150°C vorgewärmten Harz gemischt. Das Gemisch wird bei einem Vakuum von 26 Inch Hg während 15 Minuten entgast. Die Schmelze wird danach in 1/8'' dicke flächenförmige Formwerkzeuge gegossen und nach folgendem Zyklus gehärtet:

2 Std. bei 80°C
1 Std. bei 100°C
4 Std. bei 150°C
7 Std. bei 200°C

Auf dieser Art wird eine ganz ausgehärtete Platte erhalten. Dieses System wird als Harz A definiert.

*Beispiel 2*

Das Vorgehen gemäss Beispiel 1 wird auf identische Weise wiederholt, mit der Ausnahme, dass 2,6 Teile, 5,2 Teile, 7,8 Teile bzw. 13,0 Teile des Polyimids eingesetzt werden. Die resultierenden Systeme werden als Harze B, C, D und E bezeichnet.

*Beispiel 3*

Jedes der gemäss den Beispielen 1 und 2 hergestellten Harzsysteme ergibt ein klares einheitliches Harz-Stoffgemisch. In jedem Fall verläuft die Reaktion mit dem Härter problemlos und liefert durchgehärtete undurchsichtige oder offenbar zwei Phasen enthaltende Platten. Gemäss Versuch stellen sich die Undurchsichtigkeit oder die Bildung der zweiten Phase beim Gelpunkt des Harz-/Härter-Gemisches ein. Mit optisch-mikroskopischer Untersuchung bei tausendfacher Vergrösserung können keine getrennten Regionen einer zweiten Phase gefunden werden. Deshalb wird angenommen, dass sich die zweite Phase auf molekularem Niveau bildet.

Um den Einfluss der Polyimidzugabe zum Epoxyharz-/Härter-System zu bestimmen, wird eine Kontrollplatte aus 100 Teilen Araldite 6010 und 30 Teilen Härter (Beispiel 1) hergestellt und nach dem in Beispiel 1 beschriebenen Verfahren gehärtet. Die physikalischen und mechanischen Eigenschaften der oben erwähnten Harzsysteme werden mit dem Kontrollsystem verglichen.

*I.* Die Dichten von einigen gehärteten Systemen werden nach der in ASTM-D-792 beschriebenen Verdrängungsmethode gemessen. Man erhält die folgenden Resultate.

| *Harz* | *Spez. Gewicht (S.G.) bei 25°C* |
|---|---|
| Kontrolle | 1,2408 |
| A | 1,2441 |
| B | 1,2414 |
| C | — |
| D | 1,2432 |
| E | 1,2441 |
| (Polyimid) | 1,20 |

Es wäre zu erwarten, dass die Kombination von Epoxyharz/Härter (S.G. = 1,2408) mit dem Polyimid (S.G. = 1,20) einen Stoff mit einem spezifischen Gewicht von weniger als 1,2408 ergeben würde. Das ist aber nicht der Fall, da alle kombinierten Systeme spezifische Gewichte höher als 1,2408 haben. Offenbar füllt das Polyimid den Mikro-Lunker zwischen den Ketten des Epoxyharz-/Härter-Systems, ohne dass das Epoxy-Netzwerk verschoben wird. Das würde zu einer Erhöhung der Dichte des Harzsystems im Vergleich mit der Kontrolle führen. Die Zugabe des Polyimids reduziert tatsächlich das freie Volumen des Systems.

*II.* Das freie Volumen beeinflusst auch die Glasumwandlungstemperatur (Tg) eines Polymers. Je weniger freies Volumen für die Rotation der Polymerketten vorhanden ist, desto höher ist die Glasumwandlungstemperatur. Deshalb wäre zu erwarten, dass die Wärmeformbeständigkeit (HDT) des Systems erhöht wird, falls die Zugabe des Polyimids eine Reduktion des freien Volumens verursacht. Diese Erwartung hat sich hier bestätigt. Die HDT-Werte und die Glasumwandlungstemperaturen der erfindungsgemässen Systeme und des Kontrollsystems sind unten angegeben. Die HDT-Werte werden nach ASTM D-648 bestimmt, und der Tg wird auf einem Parkin-Elmer TMA (thermisch-mechanische Analyse) mit 20°C/min und mit einem Gewicht von 40 g nach der Eindringungsmethode gemessen.

| *Harz* | *HDT (°C)* | *Tg (°C)* |
|---|---|---|
| Kontrolle | 160 | 180 |
| A | 199 | 193 |
| B | 168 | 181 |
| C | 177 | 184 |
| D | 182 | 191 |
| E | 206 | 196 |

*III.* Weiterhin würde man in einem System, in dem das Polyimid mit einem Epoxyharz/Härter-Gemisch nur gut vermischt ist, zwei Glasumwandlungspunkte erwarten. Um die Zahl der Glasumwandlungspunkte zu bestimmen, wird eine dynamisch-mechanische Analyse (DMA) auf einem DuPont DMA-Gerät mit einer Temperatursteigerungsrate von 5°C/min für die Kontrolle sowie für das Harzsystem aus Beispiel 1 durchgeführt. Es werden folgende Daten erhalten:

| *Probe* | *Übergänge alpha* | *(Tg)* | *Youngscher Modul bei 25°C* |
|---|---|---|---|
| Epoxyharz/Härter | —45°C | 179°C | 1,7 GPa |
| Polyimid/Epoxyharz/Härter | —45°C | 199°C | 2,1 GPa |

Beide untersuchten Proben haben tiefe alpha-Übergänge bei —45°C, was offenbar für ein Epoxyharz/Härter-System charakteristisch ist. Die Zugabe des Polyimids scheint die Glasumwandlungstemperatur zu erhöhen und resultiert in nur einer Glasumwandlungstemperatur. Das stimmt mit den vorher diskutierten TMA- und DMA-Resultaten überein. Ausserdem ist der mit DMA gemessene Youngsche Modul (Steifheit) wesentlich erhöht. Das ist mit der Vorstellung vereinbar, dass das freie Volumen des Epoxysystems durch die Zugabe des Polyimids reduziert wird.

Ferner wenn die durch die Zugabe des Polyimids verursachte Erhöhung des Glasüberganges des Systems ihren Grund in dem höheren Glasübergang des Polyimids hat, dann sollte der resultierende optimale Glasübergang durch das Mischgesetz bestimmt sein. Wenn man in Betracht zieht, dass das Epoxyharz/Härter-System eine Tg von ca. 180°C und das Polyimid eine Tg von ca. 325°C hat, dann würde man auf Grund des Mischgesetzes für das 8%ige System eine Tg von 190°C erwarten, was unterhalb der gemessenen 200°C liegt. Dementsprechend muss es sich hier um ein anderes Phänomen handeln.

*IV.* Man kann auch annehmen, dass — falls die Zugabe des Polyimids wirklich das freie Volumen des Systems beeinflusst — das Molekulargewicht des Polyimids bezüglich der erzielten Eigenschaften keine grosse Rolle spielen wird. Um das zu bestätigen, werden Polyimide gemäss Beispiel 1 mit verschiedenen Molekulargewichten, bestimmt mit der logarithmischen Viskositätszahl (0,5% in N-Methylpyrrolidon bei 25°C) dem Epoxyharz/Härter-System in einer Menge von 10,4 Teilen zugegeben und wie unten beschrieben geprüft. Es wird jeweils die in Beispiel 1 beschriebene Methode angewendet.

Die Epoxyharz/Polyimid-Gemische sind vor der Zugabe des Härters klar. Deren Viskosität (gemessen mit einem Konus/Platte-Viskosimeter bei 100°C) hängt in folgender Weise von der Grenzviskositätszahl (GVZ) des Polyimids ab:

| *Polyimid, GVZ* | *Viskosität bei 100°C (Pa·s)* |
|---|---|
| 0,39 | 0,8 - 0,9 |
| 0,70 | 1,1 - 1,2 |
| 1,11 | 1,4 - 1,5 |

Nach dem Härten dieser Systeme nach Beispiel 1 erhält man den Polyimiden, die die GVZ 0,7 und 1,11 haben, undurchsichtige Platten, während das Polyimid mit GVZ 0,39 eine durchsichtige Harzplatte ergibt. Die Durchsichtigkeit bzw. Undurchsichtigkeit des Harzes hängt von der Anwesenheit von Komponenten mit höherem Molekulargewicht, die eine zweite Phase bilden, ab. Die Eigenschaften des Harzes werden dadurch im allgemeinen nicht beeinflusst.

Die für jedes System bestimmten Wärmebeständigkeiten (HDT) sind ähnlich.

| *Grenzviskositätszahl (GVZ)* | *Wärmebeständigkeit (HDT)* |
|---|---|
| 0,39 | 200°C |
| 0,70 | 195°C |
| 1,11 | 195°C |

Aus diesen Resultaten kann man schliessen, dass die Unterschiede im Molekulargewicht des Polyimids die HDT-Werte des resultierenden Harzes nicht wesentlich beeinflussen. Zum gleichen Schluss kommt man auf Grund der bei Raumtemperatur gemessenen

Zug- (ASTM D-638) und Biegeeigenschaften (ASTM D-790).

| | GVZ 0,39 | GVZ 0,70 | GVZ 1,11 |
|---|---|---|---|
| Zugfestigkeit (ksi) | 11,5 | 11,8 | 11,6 |
| Modul (ksi) | 410 | 420 | 400 |
| Dehnung (%) | 4,0 | 4,0 | 3,9 |
| Biegefestigkeit (ksi) | 20,0 | 20,0 | 20,0 |
| Modul (ksi) | 400 | 400 | 400 |

Die mechanischen und die HDT-Resultate scheinen nicht vom Molekulargewicht des Polyimids abzuhängen. Das ist im Einklang mit der Vorstellung, dass das Polyimid das freie Volumen des Systems reduziert.

*V.* Der Einfluss der Polyimidzugabe auf die verschieden mechanischen Eigenschaften des Harzsystems wird untersucht. Die Zugeigenschaften werden nach ASTM D-638 bei Raumtemperatur, 100°C und 150°C gemessen.

| *Raumtemperatur* | *Harz* | | | | | |
|---|---|---|---|---|---|---|
| | *Kontrolle* | *A* | *B* | *C* | *D* | *E* |
| Zugfestigkeit (ksi) | 8,9 | 11,9 | 11,0 | 10,5 | 9,9 | 11,9 |
| Standardabweichung (ksi) | 1,1 | 1,0 | 1,1 | 1,2 | 1,0 | 1,2 |
| Zugmodul (ksi) | 440 | 427 | 396 | 434 | 383 | 463 |
| Standardabweichung (ksi) | 25 | 37 | 18 | 84 | 30 | 37 |
| Dehnung (%) | 2,4 | 4,3 | 4,0 | 3,6 | 3,5 | 4,0 |
| Standardabweichung (%) | 0,5 | 0,4 | 0,7 | 0,7 | 0,5 | 0,5 |
| *100°C* | | | | | | |
| Zugfestigkeit (ksi) | 9,2 | 8,9 | 9,0 | — | 9,0 | 9,7 |
| Standardabweichung (ksi) | 0,2 | 0,4 | 0,4 | — | 0,3 | 0,1 |
| Zugmodul (ksi) | 278 | 255 | 250 | — | 276 | 276 |
| Standardabweichung (ksi) | 14 | 19 | 7 | — | 20 | 10 |
| Dehnung (%) | 5,9 | 6,3 | 5,6 | — | 5,7 | 7,7 |
| Standardabweichung (%) | 4 | 1,2 | 9 | — | 1,0 | 1,4 |
| *150°C* | | | | | | |
| Zugfestigkeit (ksi) | 5,3 | 6,0 | 5,8 | 6,1 | 6,0 | 6,1 |
| Standardabweichung (ksi) | 0,3 | 0,5 | 0,3 | 0,1 | 0,2 | 0,2 |
| Zugmodul (ksi) | 212 | 243 | 242 | 240 | 239 | 230 |
| Standardabweichung (ksi) | 20 | 14 | 12 | 16 | 12 | 8 |
| Dehnung (%) | 11,2 | 9,5 | 7,1 | 6,1 | 6,9 | 11,3 |
| Standardabweichung (%) | 4,2 | 2,3 | 0,6 | 1,3 | 1,7 | 2,6 |

Die Zugfestigkeiten von allen mit Polyimid modifizierten Systemen sind denen des Kontrollsystems überlegen. Die Modul-Werte der modifizierten Systeme sind praktisch mit der Kontrolle identisch, wenn man die experimentelle Streuung in Betracht zieht. Es sollte jedoch vermerkt werden, dass die Modul-Werte des modifizierten Systems bei 150°C höher sind als die des Kontrollsystems. Dieses Resultat deutet auf eine Verbesserung der thermischen Eigenschaften dieser Systeme hin. Die Zugdehnungen aller modifizierten Systeme sind der des Kontrollsystems überlegen. Dies zeigt, dass die modifizierten Systeme zäher und weniger anfällig sind, und dass es im Vergleich mit der Kontrolle mehr Energie braucht, um einen Bruch zu verursachen.

*VI.* Die Biegeeigenschaften der Systeme werden nach der ASTM Methode D-790 bestimmt. Bei Raumtemperatur, bei 100°C und bei 150°C werden die folgenden Werte erhalten:

| *Raumtemperatur* | *Harz* | | | | | |
|---|---|---|---|---|---|---|
| | *Kontrolle* | *A* | *B* | *C* | *D* | *E* |
| Biegefestigkeit (ksi) | 17,8 | 19,6 | 18,3 | 20,1 | 19,2 | 19,8 |
| Standardabweichung (ksi) | 2,3 | 1,0 | 4,9 | 1,9 | 0,7 | 2,4 |
| Biegemodul (ksi) | 430 | 402 | 412 | 445 | 372 | 406 |
| Standardabweichung (ksi) | 16 | 9 | 39 | 18 | 20 | 11 |

*(Fortsetzung)*

| *Raumtemperatur* | | | | *Harz* | | |
|---|---|---|---|---|---|---|
| | *Kontrolle* | *A* | *B* | *C* | *D* | *E* |
| *100°C* | | | | | | |
| Biegefestigkeit (ksi) | 14,0 | 14,3 | 13,7 | — | 12,9 | 14,3 |
| Standardabweichung (ksi) | 0,2 | 0,4 | 0,2 | — | 0,8 | 0,1 |
| Biegemodul (ksi) | 308 | 310 | 305 | — | 297 | 325 |
| Standardabweichung (ksi) | 10 | 15 | 18 | — | 10 | 9 |
| *150°C* | | | | | | |
| Biegefestigkeit (ksi) | 8,5 | 10,0 | 9,0 | 9,7 | 9,3 | 10,0 |
| Standardabweichung (ksi) | 0,2 | 0,2 | 0,2 | 0,2 | 0,1 | 0,9 |
| Biegemodul (ksi) | 240 | 259 | 241 | 247 | 252 | 265 |
| Standardabweichung (ksi) | 7 | 5 | 8 | 5 | 5 | 7 |

Die Resultate zeigen, dass die Zugabe des Polyimids die Gesamtfestigkeit und Zähigkeit des gehärteten Harzes verbessert, ohne den Biegemodul wesentlich zu beeinflussen. Ausserdem ist es ersichtlich, dass die Zugabe des Polyimids die Eigenschaften bei höheren Temperaturen verbessert.

*VII.* Um die Analyse der Harzeigenschaften zu vervollständigen, werden bei Raumtemperatur Druckversuche nach ASTM D-695 durchgeführt. Die Resultate sind nachstehend zusammengefasst.

| | | | | *Harz* | | |
|---|---|---|---|---|---|---|
| | *Kontrolle* | *A* | *B* | *C* | *D* | *E* |
| Modul (ksi) | 269 | 280 | 258 | 255 | 252 | 290 |
| Standardabweichung (ksi) | 12 | 9 | 8 | 6 | 7 | 8 |
| Quetschfestigkeit (ksi) | 19,6 | 20,5 | 19,9 | 19,8 | 20,2 | 22,9 |
| Standardabweichung (ksi) | 0,2 | 0,2 | 0,1 | 0,1 | 0,8 | 0,3 |
| Bruchfestigkeit (ksi) | 30,4 | >40 | 33,0 | 30,0 | 31,2 | >40 |
| Standardabweichung (ksi) | 6,4 | — | 3,9 | 4,2 | 5,5 | — |
| Zusammenpressen[1] (%) | 14,5 | 15,2 | 14,7 | 14,9 | 15,0 | 15,6 |
| Standardabweichung (%) | 0,9 | 1,0 | 0,8 | 0,4 | 0,0 | 0,5 |
| Zusammenpressen beim Bruch[2] (%) | 37,5 | >44 | 38,7 | 36,1 | 36,3 | >44 |
| Standardabweichung (%) | 5,4 | — | 3,2 | 4,0 | 4,6 | — |

[1] Abweichung, bezogen auf die ursprüngliche Probenlänge, bei der es zu einer permanenten plastischen Deformation kommt und bei der sich der Modul verändert.

[2] % Abweichung, bezogen auf die ursprüngliche Probenlänge, bei der es zum Bruch kommt.

Die Druckmoduln der Systeme werden durch grössere Polyimidkonzentration erhöht. Dies deutet wiederum auf eine Verringerung des freien Volumens hin. Die Druckfestigkeiten bei höheren Polyimidkonzentrationen werden dermassen verbessert, dass die Proben mit dem Prüfgerät nicht mehr gebrochen werden können. Die Quetschfestigkeit ist normalerweise ein gutes Indiz für die Vernetzungsdichte, indem sie bei höherer Vernetzungsdichte auch grösser wird. Da das Polyimid als thermoplastisches Material einem Duroplast beigegeben wird, sollte die Vernetzungsdichte des Systems bei zunehmender Menge an Polyimid kleiner werden. Man würde also eine Reduktion der Quetschfestigkeit erwarten. Dies ist nicht der Fall, da die Quetschfestigkeit mit höherer Polyimidkonzentration zunimmt.

*VIII.* Die Feuchtigkeitsaufnahmeeigenschaften der modifizierten Harzsysteme werden untersucht. Die Gewichtszunahmen werden nach 25 Tagen bei 100% relativer Luftfeuchtigkeit und 70°C (Sättigung) gemessen und sind in Prozenten vom Ausgangsgewicht angegeben.

| *Harz* | *% Feuchtigkeitsaufnahme* |
|---|---|
| Kontrolle | 2,5 |
| A | 2,8 |
| B | 2,7 |
| C | 2,8 |
| D | 2,7 |
| E | 2,8 |

Obwohl der Prozentsatz der Wasseraufnahme mit der Zugabe des Polyimids zunimmt, sind die mechanischen Eigenschaften des gehärteten Systems bei erhöhter Temperatur nach Feuchtigkeitseinwirkung, ein bedeutsamerer Test für die Beständigkeit gegen Feuchtigkeitseinfluss.

| | | | | *Harz* | | |
|---|---|---|---|---|---|---|
| | *Kontrolle* | *A* | *B* | *C* | *D* | *E* |
| *100°C* | | | | | | |
| Zugfestigkeit (ksi) | 5,3 | 5,8 | 5,4 | — | 5,9 | 6,2 |
| Standardabweichung (ksi) | 0,1 | 0,2 | 0,1 | — | 0,2 | 0,1 |
| Zugmodul (ksi) | 294 | 333 | 278 | — | 310 | 471 |
| Standardabweichung (ksi) | 54 | 49 | 20 | — | 39 | 100 |
| Dehnung (%) | 5,8 | 5,5 | 5,4 | — | 6,6 | 8,9 |
| Standardabweichung (%) | 0,7 | 0,9 | 0,7 | — | 1,6 | 1,9 |
| Biegefestigkeit (ksi) | 8,6 | 9,8 | 8,6 | 9,2 | — | — |
| Standardabweichung (ksi) | 0,3 | 0,2 | 0,2 | 0,4 | — | — |
| Biegemodul (ksi) | 260 | 270 | 205 | 213 | — | — |
| Standardabweichung (ksi) | 12 | 37 | 4 | 18 | — | — |

Eine Untersuchung der oben erwähnten Resultate deutet darauf hin, dass die Polyimid-modifizierten Systeme im allgemeinen bei erhöhter Temperatur verbesserte Zug- und Biegefestigkeiten und Moduln, sowie verbesserte Zugdehnung haben, obwohl die Feuchtigkeitsaufnahme durch den Zusatz des Polyimids zunimmt. Demnach werden die Eigenschaften des modifizierten Systems unter Feuchtigkeitseinwirkung durch die Zugabe des Polyimids verbessert.

*IX.* Letztlich werden Schlagbiegezähigkeitsversuche nach Charpy (ASTM Methode D-256) durchgeführt, und es werden die folgenden Resultate erhalten:

| | | | | *Harz* | | |
|---|---|---|---|---|---|---|
| | *Kontrolle* | *A* | *B* | *C* | *D* | *E* |
| Schlagbiegezähigkeit nach Charpy | 7,0 | 13,3 | 13,0 | 11,0 | 9,3 | 15,1 |
| Standardabweichung | 5,0 | 4,9 | 7,3 | 8,7 | 4,9 | 3,9 |

Wie schon vorher für die Zug- und Biegeeigenschaften gefunden, erhöht die Zugabe des Polyimids auch hier die Zähigkeit. Die oben erwähnten Charpy-Messungen verkörpern die Energiemenge, die benötigt wird, um einen Bruch zu verursachen oder um ihn weiterzuverbreiten. Die Zugabe beliebiger Mengen Polyimid zum System erhöht die Schlagbiegezähigkeit, aber die grössten Verbesserungen werden bei hohen Polyimidkonzentrationen beobachtet.

*Beispiel 4*

Folgende Formulierungen werden hergestellt:

| | TEILE | | | | | |
|---|---|---|---|---|---|---|
| Araldite 6010 | 100 | 100 | 100 | 100 | 100 | 100 |
| Polyimid (Beispiel 1) | 25 | 30 | 35 | 40 | 45 | 50 |
| Methylenchlorid | 200 | 208 | 216 | 224 | 232 | 240 |

Nach Entfernung des Methylenchlorids unter reduziertem Druck werden in jedem der Fälle klare Epoxyharze erhalten.

*Beispiel 5*

Das folgende Harzgemisch wird hergestellt und verarbeitet:

| | *Teile* |
|---|---|
| Araldite 6010 | 50 |
| Triglycidyliertes p-Aminophenol* | 50 |
| Polyimid (Beispiel 1) | 14 |
| Methylenchlorid | 150 |

* Harz 0510 von CIBA-GEIGY Corp., U.S.A.

Es wird eine Lösung von 6010 und 0510 in Methylenchlorid hergestellt, und das Polyimid wird dazugegeben. Das Gemisch wird bis zur Lösung bei 44°C rückflussiert. Die Lösung wird filtriert, das Methylenchlorid wird unter reduziertem Druck abgedampft, die Temperatur wird auf 125°C erhöht, und das System wird bei 125°C und 50 mm Hg evakuiert, um eventuell vorhandene flüchtige Komponenten zu entfernen. Das resultierende Harz wird heiss entleert. Das ergibt ein klares, harzartiges Material, das sich mit den üblichen Epoxyhärtern härten lässt. Harzplatten aus reinem Harz werden durch Härtung mit dem Sulfon aus Beispiel 1 (Harz F), und mit dem hiernach beschriebenen Härter (Harz G), nach der im Beispiel 1 angegebenen Methode hergestellt. Die Formulierungen und die resultierenden Eigenschaften sind unten angegeben.

Das im Harz G verwendete Härtergemisch wird wie oben beschrieben hergestellt und verarbeitet.

| | *Teile* |
|---|---|
| Flüssiges modifiziertes aromatisches Amin auf Basis von Bis(4-amino-phenyl)methan | 100 |
| Polyimid (Beispiel 1) | 30,8 |
| Methylenchlorid | 392 |

Das ergibt einen klaren, halbfesten Härter der Epoxyharze härtet.

| | *Harz* | |
|---|---|---|
| | *F* | *G* |
| *Formulierung:* | | |
| Harz (Beispiel 5) (Teile) | 100 | 100 |
| Bis(4-aminophenyl)sulfon (Teile) | 36,6 | — |
| Härter (Beispiel 5) (Teile) | — | 48 |
| *Eigenschaften:* | | |
| Zugfestigkeit (ksi) | 9,7 | 8,3 |
| Standardabweichung (ksi) | 0,4 | 0,4 |
| Zugmodul (ksi) | 480 | 497 |
| Standardabweichung (ksi) | 13 | 9 |
| Dehnung (%) | 2,7 | 1,9 |
| Standardabweichung (%) | 0,2 | 0,1 |
| Biegefestigkeit (ksi) | 21,1 | — |
| Standardabweichung (ksi) | 1,3 | — |
| Biegemodul (ksi) | 450 | — |
| Standardabweichung (ksi) | 10 | — |
| HDT (°C) | 229 | 200 |

*Beispiel 6*

Die folgenden Formulierungen werden nach der im Beispiel 5 angegebenen Methode hergestellt, mit der Ausnahme, dass das Lösungsmittel durch Erhitzen statt unter reduziertem Druck entfernt wird.

| | * *Teile* | | | | | | | | | |
|---|---|---|---|---|---|---|---|---|---|---|
| Polyimid (Beispiel 1) | 10,0 | 10,0 | 5,0 | 10,0 | 10,0 | 10,0 | 10,0 | 10,0 | 10,0 | 12,0 |
| Methylenchlorid | 100,0 | — | 100,0 | 100,0 | 200,0 | 200,0 | 200,0 | 200,0 | 200,0 | 150,0 |
| Dimethylformamid | — | 122,0 | — | — | — | — | — | — | — | — |
| Festes bromhaltiges Epoxyharz (1) | 90,0 | 90,0 | — | — | — | — | — | — | — | — |
| Tetraglycidyliertes Dimethylanilin (2) | — | — | 95,5 | 90,0 | — | — | — | — | — | — |
| Araldite 6010 | — | — | — | — | 80,0 | 70,0 | — | — | — | — |
| Epoxy-Kresol-Novolak-Harz (3) | — | — | — | — | 20,0 | — | 20,0 | 30,0 | 40,0 | — |
| Epoxy-Kresol-Novolak-Harz (4) | — | — | — | — | — | 30,0 | — | — | — | — |
| Diglycidyläther von Tetrabrombisphenol A (5) | — | — | — | — | — | — | 80,0 | 70,0 | 60,0 | — |
| Epoxy-Phenol-Novolak-Harz (6) | — | — | — | — | — | — | — | — | — | 100,0 |

(1) 8011 von CIBA-GEIGY Corp., U.S.A.
(2) MY-720 von CIBA-GEIGY Corp., U.S.A.
(3) ECN 9680 von CIBA-GEIGY Corp., U.S.A.
(4) ECN 9690 von CIBA-GEIGY Corp., U.S.A.
(5) LT 8049 von CIBA-GEIGY Corp., U.S.A.
(6) EPN 1138 von CIBA-GEIGY Corp., U.S.A.
* Das Lösungsmittel wird während des Härtungsvorgangs entfernt.

*Beispiel 7*

Das folgende Beispiel zeigt die Herstellung eines erfindungsgemässen modifizierten Systems ohne Lösungsmittel.

Ein Kolben wird mit 100 Teilen eines Epoxy-Phenol-Novolak-Harzes (EPN 1139 von CIBA-GEIGY Corp., U.S.A.) und 10,4 Teilen des im Beispiel 1 beschriebenen Polyimids gefüllt. Das Gemisch wird vier Stunden bei 125°C gerührt. Man erhält ein klares harzartiges Material.

*Beispiel 8*

Dieses Beispiel zeigt die Zugabe des Polyimids in Form eines Gemisches mit der Härterkomponente.

Nach der im Beispiel 6 beschriebenen Methode werden die folgenden Formulierungen hergestellt:

| | *TEILE* | | | |
|---|---|---|---|---|
| o-Kresol-Formaldehyd-Novolak (7) | 100,0 | — | — | — |
| 4,4'-diaminodiphenylsulfon | — | 100,0 | — | — |
| Modifiziertes aliphatisches Amin (8) | — | — | 100,0 | — |
| Methylnadicanhydrid (9) | — | — | — | 100,0 |
| Polyimid (Beispiel 1) | 19,0 | 31,4 | 20,0 | 17,5 |
| Methylenchlorid | — | — | 150,0 | 150,0 |
| Tetrahydrofuran | 250,0 | 300,0 | — | — |

(7) HT 9490 von CIBA-GEIGY Corp., U.S.A.
(8) ARALDIT Härter 956 von CIBA-GEIGY Corp., U.S.A.
(9) Härter 906 von CIBA-GEIGY Corp., U.S.A.

In jedem Fall wird eine einphasige Schmelze erhalten.

*Beispiel 9*

Die folgenden Prüfungen werden durchgeführt, um die Anwendbarkeit der erfindungsgemässen modifizierten Systeme für den Gebrauch in Verbundstoffen zu zeigen.

Um die Nützlichkeit des Harzes A in Verbundstoffen zu zeigen, werden Graphit-verstärkte Platten hergestellt. Präpregs werden aus einer Lösung der Komponenten in Tetrahydrofuran hergestellt und um eine Trommel gewickelt. Der nicht-orientierte Präpreg wird ausgelegt und 2,5 Stunden bei 175°C verpresst. Der Harzgehalt des gehärteten Laminats ist 32 ± 2 Gewichtsprozent. Verschiedene mit diesem Laminat durchgeführte Prüfungen sind unten zusammengefasst.

| *Test* | *Temperatur* | *Durchschnitt* | *Bereich* |
|---|---|---|---|
| 0° Zug: | | | |
| Reissfestigkeit (ksi) | RT | 311 | 280-346 |
| Spannungsmaximum (%) | RT | 1,45 | 1,32-1,57 |
| Zugmodul (Msi) | RT | 22,7 | 18,1-26,3 |
| 0° Druck: | | | |
| Druckfestigkeit (ksi) | RT | 210 | 183-238 |
| Druckfestigkeit (ksi)* | 93°C | 180 | 169-187 |
| * getestet nach 14 Tagen Verbleib in Wasser bei 70°C | | | |
| 0° Schwerversuch am kurzen Prüfkörper: | | | |
| Scherfestigkeit (ksi) | RT | 15,2 | 14,7-15,5 |
| ± 45/90 Zugbeanspruchung: | | | |
| Last-Durchbiegungskurve (%) | RT | 1,1 | 1,05-1,15 |
| Spannungsmaximum (%) | RT | 1,35 | 1,3-1,4 |

*Umwelteinflüsse:*

| *Umwelt* | *Temperatur* | *Dauer* | *Gewichtszunahme* |
|---|---|---|---|
| Wasser | 70°C | 14 Tage | 0,7% |
| Skydrol* | 70°C | 14 Tage | 0,3% |
| Methyläthylketon | RT | 14 Tage | 0,6% |

* Mischung von aliphatischen und aromatischen Kohlenwasserstoffen, die als hydraulische Flüssigkeit verwendet wird (Markenname der Monsanto).

Diese Resultate zeigen die ausgezeichneten Eigenschaften, die durch den Gebrauch des Polyimid-modifizierten Systems als Matrixharz in Verbundstoffen erreicht werden.

*Beispiel 10*

Die folgenden Resultate zeigen, dass durch die Zugabe einer kleinen Menge Polyimid die Viskosität der Harze 6010 und MY 720 auf voraussagbare Weise kontrolliert werden kann. Die Viskositäten werden mit einem Konus/Platte-Viskosimeter bei 100°C gemessen.

| Polyimid % | 6010 | MY 720 |
|---|---|---|
| 0 | 400 cP | 1 600 cP |
| 1 | 400 cP | 1 600 cP |
| 3 | 800 cP | 3 200 cP |
| 6 | 2 000 cP | 6 400 cP |
| 12 | 6 800 cP | — |

Durch lineare Regression der gemessenen Viskositäten in Abhängigkeit von % Polyimid werden für die beiden Harze die folgenden Gleichungen erhalten:

*Harz 6010/Polyimid:*
Viskosität bei 100°C =
543 × (% Polyimid) — 310   r = 0,96

*Harz MY 720/Polyimid:*
Viskosität bei 100°C =
838 × (% Polyimid) + 1 105   r = 0,97

Wie aus den Resultaten ersichtlich ist, zeigen zwei verschiedene Typen von Epoxyharz, 6010 und MY 720, ähnliches Fliessverhalten. Die durch die Zugabe des Polyimids verursachten Viskositätsänderungen ermöglichen es, die Viskosität eines Systems nach Wunsch in voraussehbarer Weise einzustellen. Folglich kann die gewünschte Viskosität in Abhängigkeit von der Menge und vom Molekulargewicht des Polyimids erhalten werden.

Zusammenfassend kann man sagen, dass die vorliegende Erfindung Epoxyharzsysteme mit verbesserten Eigenschaften liefert, und dass diese Verbesserungen durch die Einführung einer im wesentlichen diskontinuierlichen Phase eines thermoplastischen Materials bewirkt werden. Die einzelnen Verfahren, Verhältnisse und Materialien können innerhalb des beanspruchten Erfindungsgegenstandes variiert werden.

**Patentansprüche**

1. Stoffgemische enthaltend (a) ein Epoxyharz mit mehr als einer Epoxygruppe, und (b) ein Polyimid, das im wesentlichen aus wiederkehrenden Einheiten der Formel

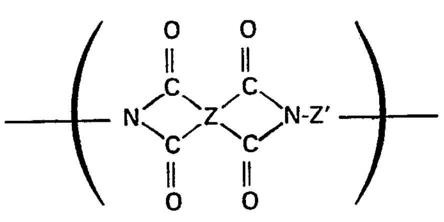

(I)

besteht, worin die vier Carbonylgruppen direkt an verschiedene Kohlenstoffatome gebunden sind und sich in ortho- oder peri-Stellung zueinander befinden, so dass fünf- oder sechsgliedrige Imidringe gebildet werden;

Z ein vierwertiger Rest ist, der mindestens einen aromatischen Ring enthält, worin die Carbonylgruppen an den Ring gebunden sind, und

Z' ein zweiwertiger organischer Rest ist ausgewählt aus aromatischen, aliphatischen, alkylaromatichen, cycloaliphatischen und heterocyclischen Resten deren Kombinationen, und Resten mit Heteroatome enthaltenden überbrückenden Gruppen, wobei das Heteroatom in der Brücke Sauerstoff, Schwefel, Stickstoff, Silizium oder Phosphor ist; wobei das Polyimid (b) in einer Konzentration von 0,5 bis 50 Gewichtsprozent, bezogen auf das Stoffgemisch, und als eine im wesentlichen diskontinuierliche Phase innerhalb des Epoxyharzes vorliegt.

2. Stoffgemische nach Anspruch 1, worin das Epoxyharz ein Epoxyharz auf der Basis von mehrwertigen Phenolen, ein Epoxidierungsprodukt von Kresol-Novolaken, ein Epoxidierungsprodukt von Phenol-Novolaken, ein Hydantoin Epoxyharz, ein Polyglycidylester, ein glycidyliertes aromatisches Amin, ein glycidyliertes Aminophenol und/oder ein cycloaliphatisches Epoxyharz ist.

3. Stoffgemische nach Anspruch 2, worin das Epoxyharz ein Epoxydierungsprodukt eines Kresol-Novolaks oder eines Phenol-Novolaks und besonders der Diglycidyläther von Bisphenol A ist.

4. Stoffgemische nach den Ansprüchen 1 oder 3, worin das Polyimid aus Diaminophenylindan und Benzophenontetracarbonsäuredianhydrid hergestellt wird.

5. Stoffgemische nach Anspruch 1, worin das Polyimid in einer Konzentration von 1 bis 30 Gewichtsprozent, besonders von 2 bis 10 Gewichtsprozent, anwesend ist.

6. Härtbare Gemische enthaltend das Stoffgemisch nach Anspruch 1 oder 5 und mindestens einen dafür geeigneter Härter.

7. Härtbare Gemische nach Anspruch 6, worin der Härter Bis(4-aminophenyl)methan oder Dicyandiamid und insbesondere Bis(4-aminophenyl)sulfon ist.

8. Härtbare Gemische nach Anspruch 6, worin der Härter und das Stoffgemisch in stöchiometrischen Mengen ± 50% anwesend sind.

9. Das Produkt erhalten durch Härtung des Gemisches nach Anspruch 6.

10. Verfahren zur Verbesserung der Verarbeitungseigenschaften und/oder der mechanischen und thermischen Eigenschaften von Epoxyharzen, dadurch gekennzeichnet, dass man in ein Epoxyharz, mit mehr als einer Epoxygruppe als eine im wesentlichen darin diskontinuierliche Phase 0,5 bis 50 Gewichtsprozent, bezogen auf das Gesamtgemisch, eines Polyimids nach den Ansprüchen 1 oder 4, einverleibt.

11. Verfahren zur Verbesserung der Verarbeitungseigenschaften und/oder der mechanischen und thermischen Eigenschaften eines härtbaren Epoxyharz-Härter-Systems, dadurch gekennzeichnet, dass man in ein Epoxyharz mit mehr als einer Epoxygruppe, oder in einen Härter vor der Härtung des Epoxyharz-Härter-Systems, 0,5 bis 50 Gewichtsprozent, bezogen auf das Gesamtgemisch, eines Polyimids nach den Ansprüchen 1 oder 4 einverleibt, wobei das Polyimid eine im wesentlichen diskontinuierliche Phase im Epoxyharz-Härter-System bildet.

**Claims**

1. A composition containing (a) an epoxy resin having more than one epoxy group, and (b) a polyimide consisting essentially of the recurring unit of the formula

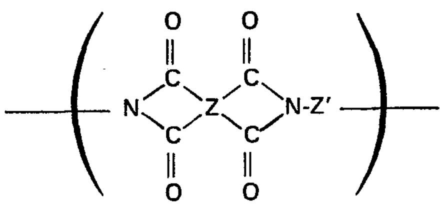

(I)

wherein the four carbonyl groups are attached directly to different carbon atoms, the carbonyl groups being ortho or peri to each other so that five- or six-membered imide rings are formed;

Z is a tetravalent radical containing at least one aromatic ring, the carbonyl groups being attached to the ring; and

Z' is a divalent organic radical selected from aromatic, aliphatic alkyl aromatic, cycloaliphatic, and heterocyclic radicals, combinations of these, and radicals with heteroatom-containing bridging groups where the heteroatom in the bridge is oxygen, sulfur, nitrogen, silicon or phosphorus; said polyimide (b) being present in a concentration of 0.5 to 50% by weight, based on said composition, and being present as a substantially discontinuous phase within the epoxy resin.

2. A composition according to claim 1, wherein the epoxy resin is an epoxy resin based on polyhydric phenols, an epoxydation product of cresol novolacs, an epoxidation product of phenol novolacs, a hydantoin epoxy resin, a polyglycidyl ester, a glycidylated aromatic amine, a glycidylated aminophenol and/or a cycloaliphatic epoxy resin.

3. A composition according to claim 2, wherein the epoxy resin is an epoxidation product of a cresol novolac or a phenol novolac or is, preferably, the diglycidyl ether of bisphenol A.

4. A composition according to either of claims 1 or 3, wherein the polyimide is prepared from diaminophenylindane and benzophenonetetracarboxylic acid dianhydride.

5. A composition according to claim 1, wherein the polyimide is present in a concentration of 1 to 30% by weight, preferably 2 to 10% by weight.

6. A curable mixture containing a composition according to either of claims 1 or 5, together with at least one hardener therefor.

7. A curable mixture according to claim 6, wherein the hardener is bis(4-aminophenyl)methane or dicyanodiamide or, preferably, bis(4-aminophenyl) sulfone.

8. A curable mixture according to claim 6, wherein the hardener and the composition are present in stoichiometric amounts ± 50%.

9. A product obtained by curing a mixture according to claim 6.

10. A method of improving the processing properties and/or the mechanical and thermal properties of epoxy resins, which method comprises incorporating into an epoxy resin having more than one epoxy group, as a substantially discontinuous phase therein, 0.5 to 50% by weight, based on the total blend, of a polyimide according to either of claims 1 or 4.

11. A method of improving the processing properties and/or the mechanical and thermal properties of a curable epoxy resin-hardener system, which method comprises incorporating into an epoxy resin having more than one epoxy group or into a hardener for said epoxy resin, prior to the curing of the epoxy resin-hardener system, 0.5 to 50% by weight, based on the total blend, of a polyimide according to either of claims 1 or 4, said polyimide forming a substantially discontinuous phase in the epoxy resin-hardener system.

**Revendications**

1. Mélanges renfermant a) une résine époxydique avec plus d'un groupe époxy et b) un polyimide qui est essentiellement constitué par des motifs répétitifs de formule:

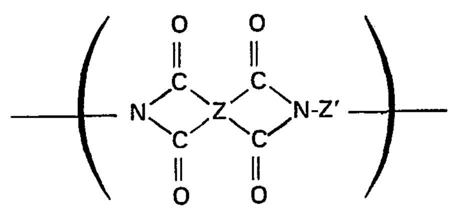

(I)

dans laquelle les quatre groupes carbonyles sont directement liés à différents atomes de carbone et se trouvent en position ortho ou péri les uns par rapport aux autres de manière à former des cycles imidiques penta- ou hexagonaux;

Z est un reste tétravalent renfermant au moins un noyau aromatique, les groupes carbonyles étant liés à ce noyau, et

Z' est un reste organique divalent choisi parmi des restes aromatiques, aliphatiques, alkylaromatiques, cycloaliphatiques et hétérocycliques ou leurs combinaisons et des restes avec des groupes de pontage contenant des hétéroatomes, l'hétéro-atome dans le pont étant l'oxygène, le soufre, l'azote, le silicium ou le phosphore; moyennant quoi le polyimide b) est présent au sein de la résine époxydique à une concentration de 0,5 à 50 pourcent en poids par rapport au mélange et en tant que phase essentiellement discontinue.

2. Mélanges selon la revendication 1, dans lesquels la résine époxydique est une résine époxydique à base de polyphénols, un produit d'époxydation de novolacs de crésol, un produit d'époxydation de novolacs de phénol, une résine hydantoïne-époxy, un ester polyglycidique, une amine aromatique glycidique, un aminophénol glycidique et/ou une résine époxydique cycloaliphatique.

3. Mélanges selon la revendication 2, dans lesquels la résine époxydique est un produit d'époxydation d'une novolaque de crésol ou d'une novolaque de phénol et en particulier l'éther diglycidique du bisphénol A.

4. Mélanges de produits selon la revendication 1 ou 3 dans lesquels le polyimide est préparé à partir de diaminophénylindane et de dianhydride benzophénonetétracarboxylique.

5. Mélanges de produits selon la revendication 1, dans lesquels le polyimide est présent à une concentration de 1 à 30 pourcent en poids, en particulier de 2 à 10 pourcent en poids.

6. Mélanges durcissables contenant le mélange de produits selon la revendication 1 ou 5 et au moins un durcisseur adapté à ceux-ci.

7. Mélanges durcissables selon la revendication 6, dans lesquels le durcisseur est le bis(amino-4 phényl)méthane ou le dicyanodiamide et en particulier la bis(amino-4 phényl) sulfone.

8. Mélanges durcissables selon la revendication 6, dans lesquels le durcisseur et le mélange de produits sont présents en des quantités stoechiométriques ± 50%.

9. Le produit obtenu par durcissement du mélange selon la revendication 6.

10. Procédé pour l'amélioration des caractéristiques de transformation et/ou des caractéristiques mécaniques et thermiques de résines époxydiques, caractérisé en ce qu'on incorpore dans une résine époxydique avec plus d'un groupe époxy sous forme d'une phase essentiellement discontinue dans celle-ci, 0,5 à 50 pourcent en poids, par rapport au mélange total, d'un polyimide selon la revendication 1 ou 4.

11. Procédé pour l'amélioration des caractéristiques de transformation et/ou des caractéristiques mécaniques et thermiques d'un système résine époxydique-durcisseur durcissable, caractérisé en ce qu'on incorpore dans une résine époxydique possédant plus d'un groupe époxy ou dans un durcisseur, avant le durcissement du système résine époxydique-durcisseur, 0,5 à 50 pourcent en poids, par rapport au poids total, d'un polyimide selon la revendication 1 ou 4, moyennant quoi le polyimide forme une phase essentiellement discontinue dans le système résine époxydique-durcisseur.